# EUROPEAN PATENT APPLICATION

(11) **EP 4 277 105 A1**
(43) Date of publication of application: **15.11.2023**
(21) Application number: 21917745.8
(22) Date of filing: 27.12.2021
(51) Int. Cl.: H02M 3/28

(54) **POWER CONVERSION DEVICE**

(30) Priority: 07.01.2021 JP 2021001556
(71) Applicant: Panasonic Intellectual Property Management Co., Ltd., Kadoma-shi, Osaka 571-0057 (JP)
(72) Inventor: YAMAKAWA, Takehiko, Kadoma-shi, Osaka 571-0057 (JP); MATSUMOTO, Hiromu, Kadoma-shi, Osaka 571-0057 (JP); NAKAMURA, Susumu, Kadoma-shi, Osaka 571-0057 (JP); MIYAMOTO, Yutaka, Kadoma-shi, Osaka 571-0057 (JP)
(74) Representative: Grünecker Patent- und Rechtsanwälte PartG mbB
(86) International application number: PCT/JP2021/048553
(87) International publication number: WO 2022/149525

(57) **Abstract**

A power conversion apparatus is provided with: a plurality of power conversion circuits each provided with a transformer and supplying DC power to a common rechargeable battery; a control circuit configured to control the power conversion circuits; and a cooling device configured to cool the power conversion circuits. The cooling device is provided with at least one flow path for a coolant, the flow path being in thermal contact with the transformers of the power conversion circuits. When a load voltage of the rechargeable battery is equal to or higher than a predetermined threshold, the control circuit operates one power conversion circuit of the plurality of power conversion circuits, the one power conversion circuit provided with the transformer having a largest thermal contact area with the flow path, and stops operations of other power conversion circuits of the plurality of power conversion circuits.

## Description

### TECHNICAL FIELD

The present disclosure relates to a power conversion apparatus, a method for controlling the power conversion apparatus, and a charging system.

### BACKGROUND ART

Electric vehicles and plug-in hybrid vehicles are provided with an on-board power conversion apparatus that converts AC power received from a commercial AC power supply, into DC power, for charging an on-board rechargeable battery. For example, Patent Document 1 discloses a switching power supply device applicable to a charging device for an electric vehicle or a hybrid vehicle.

### CITATION LIST

### PATENT DOCUMENTS

PATENT DOCUMENT 1: Japanese Patent No. JP 6643678 B
PATENT DOCUMENT 2: Japanese Patent No. JP 6509472 B

### SUMMARY OF INVENTION

### TECHNICAL PROBLEM

Some power conversion apparatuses are configured as an isolated circuit including a transformer. In such a power conversion apparatus, the temperature of the transformer core gradually increases as the power conversion apparatus continues to operate. When the temperature of the transformer core has excessively increased, an external force is applied to the core due to thermal expansion of the transformer components (such as a bobbin and a potting), and stress occurs in the core due to a disequilibrium thermal distribution therein. As a result of such external force and stress, the core may be damaged.

For example, Patent Document 2 discloses a transformer provided with a water passage for cooling. Even if cooling the transformer using cooling water as disclosed in Patent Document 2, heat exceeding the cooling performance of the transformer may be generated depending on the magnitude of the current flowing through the transformer, and thus, the core may be damaged.

An object of the present disclosure is to provide an isolated power conversion apparatus provided with a transformer, in which a core is less likely to be damaged due to overheating of the transformer than the prior art. Another object of the present disclosure is to provide a method for controlling such a power conversion apparatus. Yet another object of the present disclosure is to provide a charging system provided with such a power conversion apparatus.

### SOLUTION TO PROBLEM

According to a power conversion apparatus of one aspect of the present disclosure, a power conversion apparatus is provided with: a plurality of power conversion circuits each provided with a transformer and supplying DC power to a common load apparatus; a control circuit configured to control the power conversion circuits; and a cooling device configured to cool the power conversion circuits. The cooling device is provided with at least one flow path for a coolant, the flow path being in thermal contact with the transformers of the power conversion circuits. When a load voltage of the load apparatus is equal to or higher than a predetermined threshold, the control circuit operates one power conversion circuit of the plurality of power conversion circuits, the one power conversion circuit provided with the transformer having a largest thermal contact area with the flow path, and stops operations of other power conversion circuits of the plurality of power conversion circuits.

### ADVANTAGEOUS EFFECTS OF INVENTION

According to the power conversion apparatus of one aspect of the present disclosure, it is possible to make the core less likely to be damaged due to overheating of the transformer than the prior art.

### BRIEF DESCRIPTION OF DRAWINGS

Fig. 1 is a block diagram illustrating a configuration of a charging system provided with a power conversion apparatus 2 according to a first embodiment.
Fig. 2 is a circuit diagram illustrating an exemplary configuration of power conversion circuits 12-1 to 12-3 of Fig. 1.
Fig. 3 is a sectional view illustrating an exemplary configuration of transformers 22-1 to 22-3 of Fig. 1.
Fig. 4 is a vertical sectional view of a housing 41 for explaining a cooling device for the power conversion apparatus 2 of Fig. 1.
Fig. 5 is a horizontal sectional view of the housing 41 for explaining the cooling device for the power conversion apparatus 2 of Fig. 1.
Fig. 6 is a graph showing exemplary changes in load power and load voltage observed when charging a rechargeable battery 3 of Fig. 1.
Fig. 7 is a graph showing thermal characteristics of an iron loss of cores 52 of the transformers 22-1 to 22-3 of Fig. 1.
Fig. 8 is a diagram illustrating thermal conduction among the transformers 22-1 to 22-3 occurring when the transformers 22-1 to 22-3 of Fig. 1 are in thermal contact with each other.
Fig. 9 is a block diagram illustrating a configuration of a charging system provided with a power conversion apparatus 2A according to a modified embodiment of the first embodiment.
Fig. 10 is a vertical sectional view of a housing 41 for explaining a cooling device for the power conversion apparatus 2A of Fig. 9.
Fig. 11 is a horizontal sectional view of the housing 41 for explaining the cooling device for the power conversion apparatus 2A of Fig. 9.
Fig. 12 is a graph schematically showing variations over time in temperatures of cores 52 of transformers 22-1 to 22-3 observed when the power conversion apparatus 2 of Fig. 1 is changed from a heavy-loaded operation to a light-loaded operation.
Fig. 13 is a flowchart illustrating a charging control process executed by a control circuit 13 of a power conversion apparatus 2 according to a second embodiment.
Fig. 14 is a timing chart illustrating operations of power conversion circuits 12-1 to 12-3 observed when executing the charging control process of Fig. 13.
Fig. 15 is a block diagram illustrating a configuration of a charging system provided with a power conversion apparatus 2B according to a first modified embodiment of the second embodiment.
Fig. 16 is a flowchart illustrating a charging control process executed by a control circuit 13B of the power conversion apparatus 2B of Fig. 15.
Fig. 17 is a graph schematically showing variations over time in temperatures of cores 52 of transformers 22-1 to 22-3 observed when executing the charging control process of Fig. 16.
Fig. 18 is a timing chart illustrating operations of the power conversion circuits 12-1 to 12-3 observed when executing the charging control process of Fig. 16.
Fig. 19 is a block diagram illustrating a configuration of a charging system provided with a power conversion apparatus 2C according to a second modified embodiment of the second embodiment.
Fig. 20 is a flowchart illustrating a charging control process executed by a control circuit 13C of the power conversion apparatus 2C of Fig. 19.
Fig. 21 is a block diagram illustrating a configuration of a charging system provided with a power conversion apparatus 2D according to a third modified embodiment of the second embodiment.
Fig. 22 is a flowchart illustrating a charging control process executed by a control circuit 13D of the power conversion apparatus 2D of Fig. 21.

### DESCRIPTION OF EMBODIMENTS

Hereinafter, embodiments according to the present disclosure will be described with reference to the drawings. However, each configuration described below is a mere example of the present disclosure. The present disclosure is not limited to the following embodiments. Besides these embodiments, various modifications can be made according to the design and the like, without departing from the technical idea of the present disclosure.

### [FIRST EMBODIMENT]

In each embodiment of the present disclosure, we will describe a power conversion apparatus, which is provided with a plurality of power conversion circuits each provided with a transformer and supplying DC power to a common load apparatus. In a first embodiment, we will describe a power conversion apparatus capable of operating only one of the plurality of power conversion circuits, that is, one power conversion circuit provided with the transformer having the highest cooling performance, in order to prevent overheating of the transformers.

### [Configuration of First Embodiment]

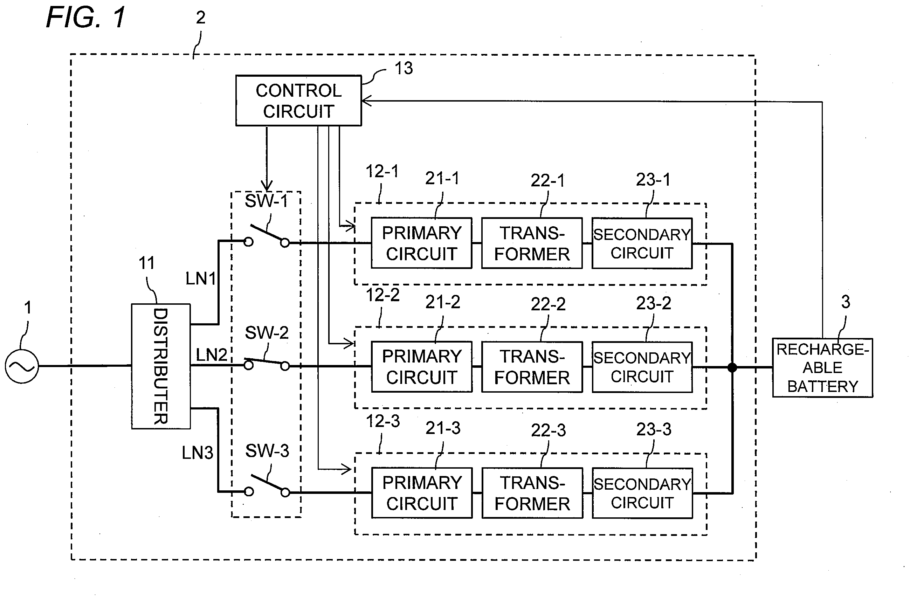

Fig. 1 is a block diagram illustrating a configuration of a charging system provided with a power conversion apparatus 2 according to the first embodiment. The charging system of Fig. 1 is provided with the power conversion apparatus 2 and a rechargeable battery 3. The power conversion apparatus 2 converts AC power supplied from an AC power supply 1, such as a commercial AC power supply, into DC power, and supplies the DC power to the rechargeable battery 3 for charging. The charging system of Fig. 1 is mounted on, e.g., an electric vehicle or a plug-in hybrid vehicle.

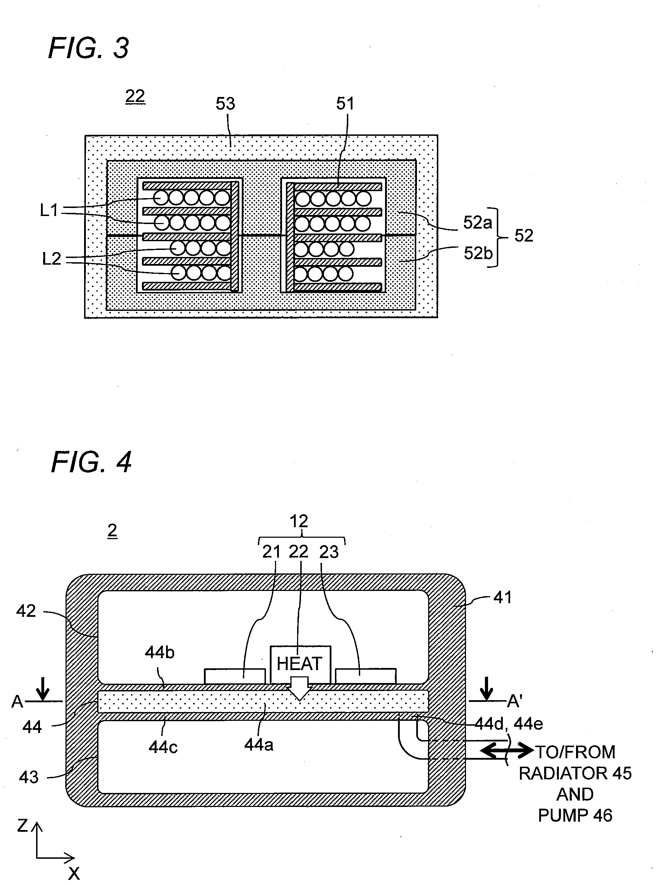

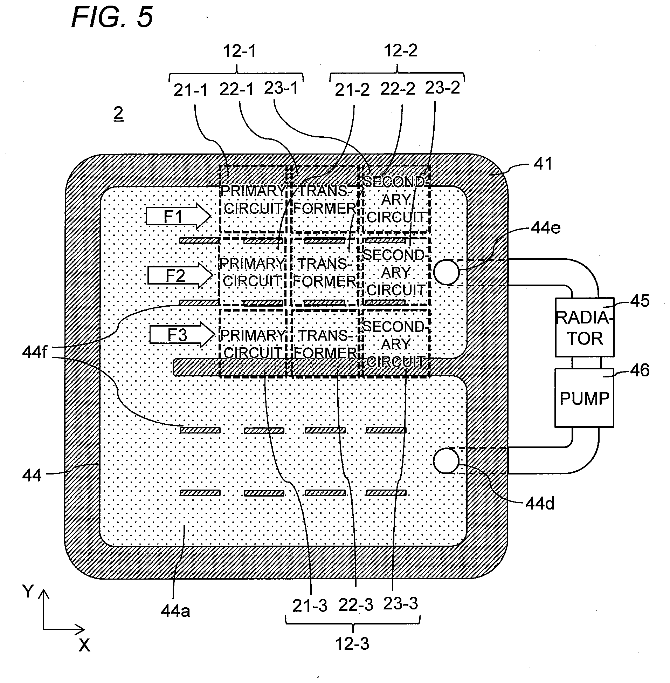

The power conversion apparatus 2 is provided with a distributor 11, switches SW-1 to SW-3, power conversion circuits 12-1 to 12-3, and a control circuit 13. In addition, the power conversion apparatus 2 is further provided with a housing 41, a radiator 45, and a pump 46, as described below with reference to Figs. 4 and 5.

The distributor 11 distributes AC power at 100 V or 200 V supplied from the AC power supply 1, to AC power of an LN1 phase, an LN2 phase, and an LN3 phase, and supplies the distributed AC power to the power conversion circuits 12-1 to 12-3 via the switches SW-1 to SW-3, respectively. The AC power supply 1 is, e.g., a three-phase AC power supply, and the LN1 phase, the LN2 phase, and the LN3 phase are, e.g., each single-phase AC power of three-phase AC power.

The switch SW-1 passes or blocks the LN1-phase AC power supplied from the distributor 11 to the power conversion circuit 12-1. The switch SW-2 passes or blocks the LN2-phase AC power supplied from the distributor 11 to the power conversion circuit 12-2. The switch SW-3 passes or blocks the LN3-phase AC power supplied from the distributor 11 to the power conversion circuit 12-3. The switches SW-1 to SW-3 are, e.g., mechanical relays or the like.

The power conversion circuit 12-1 converts the LN1-phase AC power into DC power, the power conversion circuit 12-2 converts the LN2-phase AC power into DC power, and the power conversion circuit 12-3 converts the LN3-phase AC power into DC power. Each of the power conversion circuits 12-1 to 12-3 supplies the DC power to the rechargeable battery 3 as a common load apparatus. Each of the power conversion circuits 12-1 to 12-3 generates an output voltage equal to a load voltage required to charge the rechargeable battery 3. The power conversion circuit 12-1 is provided with a primary circuit 21-1, a transformer 22-1, and a secondary circuit 23-1. In addition, the power conversion circuit 12-2 is provided with a primary circuit 21-2, a transformer 22-2, and a secondary circuit 23-2. In addition, the power conversion circuit 12-3 is provided with a primary circuit 21-3, a transformer 22-3, and a secondary circuit 23-3. Thus, the power conversion circuits 12-1 to 12-3 are configured as isolated circuits provided with the transformers 22-1 to 22-3, respectively. Output terminals of the power conversion circuits 12-1 to 12-3 are connected in parallel to the rechargeable battery 3.

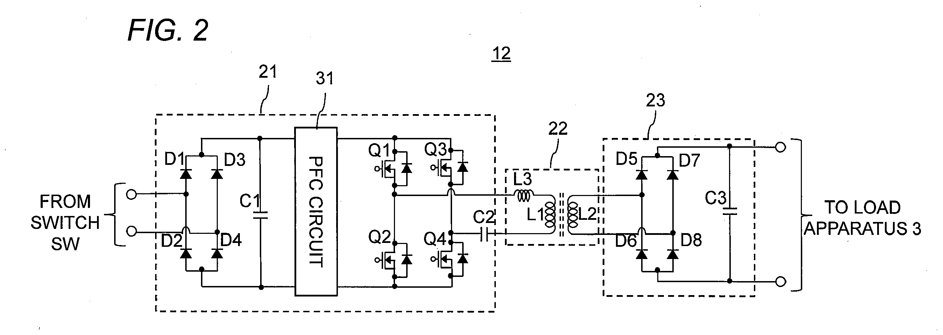

The control circuit 13 receives a control signal from the rechargeable battery 3, the control signal indicating magnitudes of a load current and a load voltage required to charge the rechargeable battery 3. The control circuit 13 controls the switches SW-1 to SW-3 and the power conversion circuits 12-1 to 12-3 to operates one, two, or three of the power conversion circuits 12-1 to 12-3, according to the required magnitudes of the load current and the load voltage. When operating any one of the power conversion circuits 12-1 to 12-3, the control circuit 13 turns on one of the switches SW-1 to SW-3 corresponding to the power conversion circuit, and operates switching elements Q1 to Q4 (described below with reference to Fig. 2) of the power conversion circuit at a certain cycle. On the other hand, when stopping operation of any one of the power conversion circuits 12-1 to 12-3, the control circuit 13 turns off one of the switches SW-1 to SW-3 corresponding to the power conversion circuit, and stops switching operations of the switching elements Q 1 to Q4 of the power conversion circuit. The control circuit 13 is configured as, e.g., a microcomputer provided with a CPU and a memory.

In the present specification, the switches SW-1 to SW-3 are also collectively referred to as "switches SW". In addition, in the present specification, the power conversion circuits 12-1 to 12-3 are also collectively referred to as "power conversion circuits 12". In addition, in the present specification, the primary circuits 21-1 to 21-3 are also collectively referred to as "primary circuits 21". In addition, in the present specification, the transformers 22-1 to 22-3 are also collectively referred to as "transformers 22". In addition, in the present specification, the secondary circuits 23-1 to 23-3 are also collectively referred to as "secondary circuits 23".

Fig. 2 is a circuit diagram illustrating an exemplary configuration of the power conversion circuits 12-1 to 12-3 of Fig. 1.

Referring to Fig. 2, the primary circuit 21 is provided with diodes D1 to D4, capacitors C1 to C2, a power factor correction (PFC) circuit 31, and the switching elements Q1 to Q4. The diodes D1 to D4 rectify the AC power of the LN1 phase, the LN2 phase, or the LN3 phase inputted via one of the switches SW-1 to SW-3. The capacitor C1 smooths the power rectified by the diodes D1 to D4. The power factor correction circuit 31 suppresses harmonics of rectified and smoothed DC power to improve the power factor. The switching elements Q1 to Q4 constitute a full-bridge inverter circuit, and convert the DC power outputted from the power factor correction circuit 31, into AC power. The switching elements Q1 to Q4 are, e.g., N-channel MOSFETs. The switching elements Q1 to Q4 are turned on/off according to control signals applied to gates thereof by the control circuit 13. The capacitor C2 is connected between the switching elements Q1 to Q4 and the primary winding L1 of the transformer 22.

In addition, referring to Fig. 2, the transformer 22 is provided with the primary winding L1 and a secondary winding L2. Each of the primary winding L1 and the secondary winding L2 has an excitation inductance. The transformer 22 further has a leakage inductance L3. The configuration of the transformer 22 will be further described with reference to Fig. 3.

In addition, referring to Fig. 2, the secondary circuit 23 is provided with diodes D5 to D8 and a capacitor C3. The diodes D5 to D8 rectify the AC power generated in the secondary winding L2 of the transformer 22. The capacitor C3 smooths the power rectified by the diodes D5 to D8. The rectified and smoothed DC power is supplied to the rechargeable battery 3.

The excitation inductance of the primary winding L1 of the transformer 22, the leakage inductance L3, and the capacitor C2 constitute an LLC resonance circuit. Therefore, the switching elements Q1 to Q4 and the capacitor C2 of the primary circuit 21, the transformer 22, and the secondary circuit 23 constitute an LLC resonance DC/DC converter circuit. LLC resonance DC/DC converter circuits are widely used in high-efficiency power supply apparatuses, such as industrial switching power supply devices, on-board charging devices, and power converters. The control circuit 13 controls the power conversion circuits 12-1 to 12-3 to bring output voltages of the power conversion circuits 12-1 to 12-3 close to the load voltage using the frequency modulation by which the switching frequency of the switching elements Q1 to Q4 is changed, while monitoring the load voltage required to charge the rechargeable battery 3. The power conversion circuits 12-1 to 12-3 can reduce switching loss by operating the switching elements Q1 to Q4 with zero-voltage switching. In addition, the power conversion circuits 12-1 to 12-3 can reduce surge currents and voltages, and reduce noise, by generating quasi-sinusoidal switching currents.

Fig. 3 is a sectional view illustrating an exemplary configuration of the transformers 22-1 to 22-3 of Fig. 1. The transformer 22 is provided with the primary winding L1 and the secondary winding L2 as described above, and further provided with a bobbin 51, a core 52, and a potting 53. The primary winding L1 and the secondary winding L2 are wound around the bobbin 51. The core 52 includes core parts 52a and 52b, and the core parts 52a and 52b sandwich the bobbin 51 around which the primary winding L1 and the secondary winding L2 are wound. The core 52 is made of, e.g., ferrite. The core 52 is embedded in the potting 53 made of silicone rubber or the like. Copper losses occur in the primary winding L1 and the secondary winding L2, an iron loss occurs in the core 52, and therefore, these losses increase temperatures of the primary winding L1, the secondary winding L2, and the core 52. The heat of the primary winding L1, the secondary winding L2, and the core 52 is released to the outside through the potting 53. In addition, the temperature difference between the core parts 52a and 52b can be reduced by conducting heat between the core parts 52a and 52b. In general, the thermal conductivity of the material used for the potting 53 is about 1 to 2 W/(m · K), whereas the thermal conductivity of the ferrite used for the core 52 is 5 W/(m · K), thus presenting high heat dissipation. The thickness of the potting 53 around the core 52 may be constant, or may vary from location to location. In the example of Fig. 3, the potting 53 at the bottom of the transformer 22 is thinner than other portions in order to facilitate heat dissipation from the core 52 to an external thermal conductor (for example, a wall 44b of the chamber 44 of Fig. 4, and the like).

Fig. 4 is a vertical sectional view of a housing 41 for explaining a cooling device for the power conversion apparatus 2 of Fig. 1. Fig. 5 is a horizontal sectional view of the housing 41 for explaining the cooling device for the power conversion apparatus 2 of Fig. 1. Fig. 5 illustrates a cross section taken along line A-A' of Fig. 4. As illustrated in Figs. 4 and 5, the power conversion apparatus 2 is further provided with a housing 41, a radiator 45, and a pump 46.

The housing 41 protects internal components thereof against water, dust, noise, and others. The housing 41 is configured by engaging a plurality of components formed by aluminum die casting or the like, with each other. The housing 41 is provided with chambers 42 to 44. The chambers 42 and 43 accommodate the components of the power conversion apparatus 2 illustrated in Fig. 1. A coolant 44a, such as cooling water, or antifreeze, such as a so-called long life coolant (LLC), etc., circulates inside the chamber 44. The coolant 44a is in thermal contact with the components of the power conversion apparatus 2 via walls 44b and 44c of the chamber 44. The chamber 44 is connected to the radiator 45 and the pump 46 external to the housing 41, via an inlet 44d and an outlet 44e. The coolant 44a circulates through the chamber 44, the radiator 45, and the pump 46 by the pump 46. The heat generated by the heat generating components of the power conversion apparatus 2 (the primary circuits 21, the transformers 22, the secondary circuits 23, and the like) moves to the coolant 44a via the walls 44b and 44c, and the heat of the coolant 44a is released from the radiator 45. The chamber 44 may be provided with one or more fins 44f in order to improve cooling performance.

In Figs. 4 and 5, for explanatory purpose, only the primary circuits 21, the transformers 22, and the secondary circuits 23 of the power conversion circuit 12 are illustrated, and the other components are omitted, among the components of the power conversion apparatus 2 illustrated in Fig. 1.

In addition, Fig. 5 schematically illustrates footprints of the primary circuits 21, the transformers 22, and the secondary circuits 23 of the power conversion circuit 12. The example of Fig. 5 shows a case where the power conversion circuits 12-1 to 12-3 have the same configuration as each other, and therefore, the primary circuits 21-1 to 21-3 have the same dimensions as each other, the transformers 22-1 to 22-3 have the same dimensions as each other, and the secondary circuits 23-1 to 23-3 have the same dimensions as each other.

As illustrated in Fig. 5, the chamber 44 includes flow paths F1 to F3 for allowing the coolant 44a to flow, the flow paths F1 to F3 being in thermal contact with at least the transformers 22-1 to 22-3, respectively. The flow paths F1 to F3 may be further in thermal contact with the primary circuits 21-1 to 21-3, and in thermal contact with the secondary circuits 23-1 to 23-3, respectively. The primary circuits 21-1 to 21-3, the transformers 22-1 to 22-3, and the secondary circuits 23-1 to 23-3 are in thermal contact with the flow paths F1 to F3 via the wall 44b of the chamber 44 (see Fig. 4). In addition, in the example of Fig. 5, the flow paths F1 to F3 may be at least partially connected to each other.

The housing 41, the radiator 45, and the pump 46 constitute a cooling device for the power conversion apparatus 2, and cool the heat generating components of the power conversion apparatus 2.

### [Operation of First Embodiment]

The magnitude of the load voltage required to charge the rechargeable battery 3 varies from the lower limit voltage to a fully-charged voltage of the rechargeable battery 3, depending on the state of charge of the rechargeable battery 3, that is, the charged voltage (hereinafter, referred to as a "voltage of the rechargeable battery 3"). The magnitudes of the load current and the load power required to charge the rechargeable battery 3 also vary depending on the state of charge of the rechargeable battery 3. The power conversion apparatus 2 changes the number of the power conversion circuits 12-1 to 12-3 in operation, depending on the magnitude of the load current or the load power required to charge the rechargeable battery 3. In general, the power conversion apparatus 2 operates all the power conversion circuits 12-1 to 12-3 in heavy-loaded conditions in which large current or large power is required to charge the rechargeable battery 3, and operates only one of the power conversion circuits 12-1 to 12-3 in light-loaded conditions in which small current or small power is required to charge the rechargeable battery 3. In the present specification, the operation of the power conversion apparatus 2 in which all the power conversion circuits 12-1 to 12-3 are in operation is referred to as a "heavy-loaded operation", and the operation of the power conversion apparatus 2 n which only one of the power conversion circuits 12-1 to 12-3 is in operation is referred to as a "light-loaded operation".

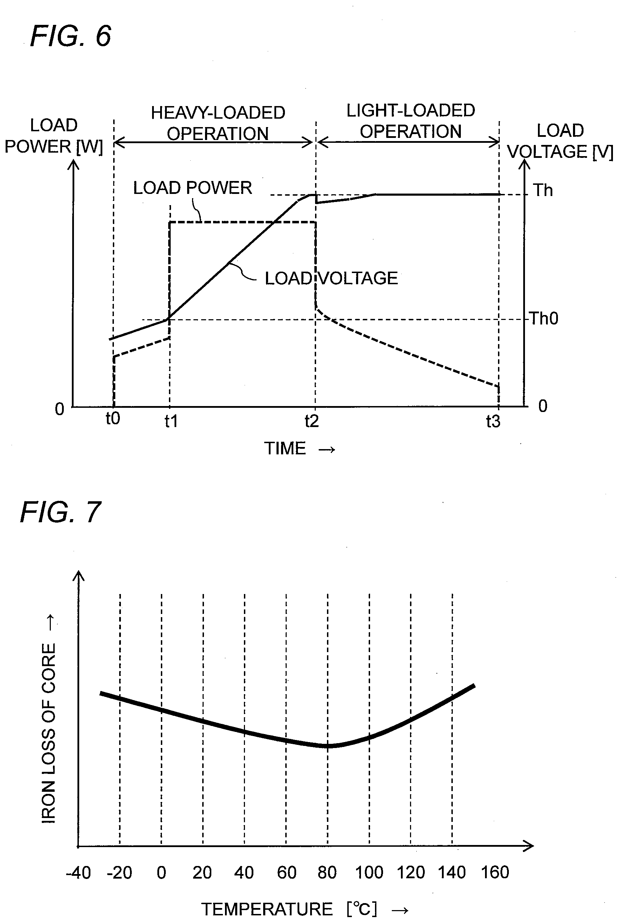

Fig. 6 is a graph showing exemplary changes in load power and load voltage observed when charging the rechargeable battery 3 of Fig. 1. When starting charging of the rechargeable battery 3, at first, the power conversion apparatus 2 operates all of the power conversion circuits 12-1 to 12-3 (heavy-loaded operation). However, in the period from time t0 to t1, when the voltage of the rechargeable battery 3 is low, the power conversion apparatus 2 charges the rechargeable battery 3 with low power, while operating all of the power conversion circuits 12-1 to 12-3, in order to prevent deterioration of the rechargeable battery 3. At this time, the power conversion apparatus 2 charges the rechargeable battery 3 with a constant current, and the load power gradually increases as the load voltage increases. The charging of the rechargeable battery 3 is continued, and at time t1, when the load voltage required to charge the rechargeable battery 3 reaches a predetermined threshold Th0 higher than the lower limit voltage of the rechargeable battery 3, the power conversion apparatus 2 increases the output power of the power conversion circuits 12-1 to 12-3, and charges the rechargeable battery 3 with a constant large power. When the voltage of the rechargeable battery 3 further increases and approaches a fully-charged voltage Th, since a voltage drop due to the internal resistance and the current of the rechargeable battery 3 is added to the load voltage, an excessive voltage is applied to the rechargeable battery 3, and therefore, the rechargeable battery 3 may be damaged, and its lifetime may be shortened. Therefore, when the load voltage reaches the fully-charged voltage Th at time t2, the power conversion apparatus 2 operates only one of the power conversion circuits 12-1 to 12-3, and stops the operations of the other power conversion circuits (light-loaded operation). Since the number of the power conversion circuits 12-1 to 12-3 in operation is reduced, and the output current is reduced, the voltage drop of the rechargeable battery 3 is reduced, and as a result, the load voltage temporarily decreases. Thereafter, the power conversion circuit in operation gradually reduces the current flowing through the rechargeable battery 3. By reducing the current flowing through the rechargeable battery 3, the voltage drop of the rechargeable battery 3 is further reduced, and the voltage of the rechargeable battery 3 approaches the fully-charged voltage Th.

As described above, the magnitudes of the load voltage, the load current, and the load power required to charge the rechargeable battery 3 all vary depending on the state of charge of the rechargeable battery 3. Therefore, the variations in the load current and the load power have a correlation with he variation in the load voltage. According to the embodiment of the present disclosure, the power conversion apparatus 2 changes the number of the power conversion circuits 12-1 to 12-3 in operation, depending on the magnitude of the load voltage, instead of the magnitude of the load current or the load power.

Fig. 7 is a graph showing thermal characteristics of an iron loss of the cores 52 of the transformers 22-1 to 22-3 of Fig. 1. In the transformer 22, copper losses occur due to currents flowing through the primary winding L1 and the secondary winding L2, and iron loss occurs due to magnetic flux flowing through the core 52. Since the magnetic flux id generated by the excitation current flowing through the primary winding L1, the magnetic flux and the iron loss increase as the excitation current increases. In addition, the excitation current increases as the output voltage increases, and the excitation current increases as the output current decreases, and therefore, as the voltage of the rechargeable battery 3 approaches the fully-charged voltage, and the output current of the power conversion circuit 12 is reduced, the iron loss increases, and the heat generation of the core 52 increases. In general, material used for the core 52 of the transformer 22, such as ferrite, has the iron loss with the thermal characteristics as illustrated in Fig. 4. The iron loss is minimized at 80 to 90 °C. During the operation of the power conversion circuit 12, when the temperature of the core 52 exceeds 80 to 90 °C, the iron loss increases, and the temperature of the core 52 further increases. The increase in the temperature of the core 52 results in a further increase in the iron loss. By repeating this cycle, thermal runaway may occur, and the core 52 of the transformer 22 may be damaged. In order to reduce thermal runaway of the transformer 22, it is important to reduce or manage heat generated by the transformer 22.

During the operation of the power conversion circuit 12, a primary current of the transformer 22 includes a current component contributing to generation of magnetic flux (that is, an excitation current), and a current component contributing to generation of a secondary current. In the heavy-loaded operation, the latter current component is dominant, and the power conversion circuit 12 operates efficiently. On the other hand, in the light-loaded operation, the output power and the output current decrease, the resonance current decreases, the excitation current not contributing to the generation of the secondary current becomes dominant, and the efficiency of the power conversion circuit 12 decreases. Therefore, in the light-loaded operation, by operating not all the power conversion circuits 12-1 to 12-3, but only one power conversion circuit, it is possible to reduce the decrease in the output current of the power conversion circuit in operation, and alleviate the decrease in efficiency.

As described below, the power conversion apparatus 2 according to the first embodiment operates only one of the plurality of power conversion circuits 12 in the light-loaded operation, that is, one power conversion circuit 12 provided with the transformer 22 having the highest cooling performance.

As illustrated in Fig. 4, the bottom surfaces of the transformers 22 are in thermal contact with the flow paths F1 to F3 via the wall 44b of the chamber 44. In addition, referring to Fig. 5, the entire bottom surface of the transformer 22-2 lies on the flow path F2, whereas parts of the bottom surfaces of the transformers 22-1 and 22-3 lie on the flow paths F1 and F3, respectively. Therefore, the area where the transformer 22-2 is in thermal contact with the flow path F2 is larger than the area where each of the transformers 22-1 and 22-3 is in thermal contact with the corresponding flow path F1 or F3. As a result, the cooling performance of the transformer 22-2 is higher than the cooling performance of each of the transformers 22-1 and 22-3. When the power conversion apparatus 2 is in the light-loaded operation, that is, when the load voltage of the rechargeable battery 3 is equal to or higher than the predetermined threshold Th, the control circuit 13 operates one of the plurality of power conversion circuits 12, the one power conversion circuit being provided with the transformer 22 having the largest thermal contact area with the corresponding one of the flow paths F1 to F3, and stops the operations of the others of the plurality of power conversion circuits 12. Therefore, in the example of Fig. 5, when the power conversion apparatus 2 is in the light-loaded operation, the control circuit 13 operates only the power conversion circuit 12-2, and stops the operations of the power conversion circuits 12-1 and 12-3. As described above, by operating the power conversion circuit 12 provided with the transformer 22 having the largest thermal contact area with the corresponding one of the flow paths F1 to F3, the power conversion circuit 12 provided with the transformer 22 having the highest cooling performance is operated, and therefore, it is possible to make the cores 52 less likely to be damaged due to overheating of the transformers 22 than the prior art.

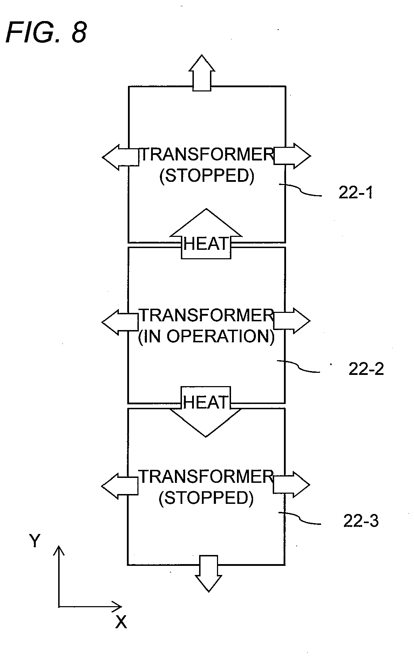

Fig. 8 is a diagram illustrating thermal conduction among the transformers 22-1 to 22-3 occurring when the transformers 22-1 to 22-3 of Fig. 1 are in thermal contact with each other. The transformer 22 of the power conversion circuit 12 having stopped its operation approaches the temperature of the coolant 44a in a relatively short time. Therefore, by arranging the transformers 22 of the power conversion circuits 12 so as to be in thermal contact with each other, it is possible to dissipate heat from the transformer 22 of the power conversion circuit 12 in operation to the transformer 22 of the power conversion circuit 12 being stopped. In particular, by bring the transformer 22 of the power conversion circuit 12 in operation into contact with the transformers 22 of the plurality of power conversion circuits 12 being sopped, it is possible to improve the cooling performance as compared with the case of bringing it into contact with the transformer 22 of one power conversion circuit 12 being stopped. When the power conversion apparatus 2 is in the light-loaded operation, the control circuit 13 operates one of the plurality of power conversion circuits 12, the one power conversion circuit being provided with the transformer 22 in thermal contact with at least two other transformers 22, and stops the operations of the others of the plurality of power conversion circuits 12. Therefore, in the example of Fig. 8, when the power conversion apparatus 2 is in the light-loaded operation, the control circuit 13 operates only the power conversion circuit 12-2 provided with the transformer 22-2, and stops the operations of the power conversion circuits 12-1 and 12-3 provided with the transformers 22-1 and 22-3. As described above, by operating the one power conversion circuit 12 provided with the transformer 22 in thermal contact with at least two other transformers 22, the power conversion circuit 12 provided with the transformer 22 having the highest cooling performance is operated, and therefore, it is possible to make the cores 52 less likely to be damaged due to overheating of the transformers 22 than the prior art.

By arranging the transformers 22 of the power conversion circuits 12 so as to be in thermal contact with each other, it is possible to operate the power conversion circuit 12 provided with the transformer 22 having the highest cooling performance, even when there is no difference in area where each transformer 22 is in thermal contact with the corresponding one of the flow paths F1 to F3. In addition, by arranging the transformers 22 such that the transformer 22 having the largest thermal contact area with the corresponding one of the flow paths F1 to F3 is in thermal contact with at least two other transformers 22, it is possible to further improve the cooling performance of the transformers 22.

### [Modified Embodiment of First Embodiment]

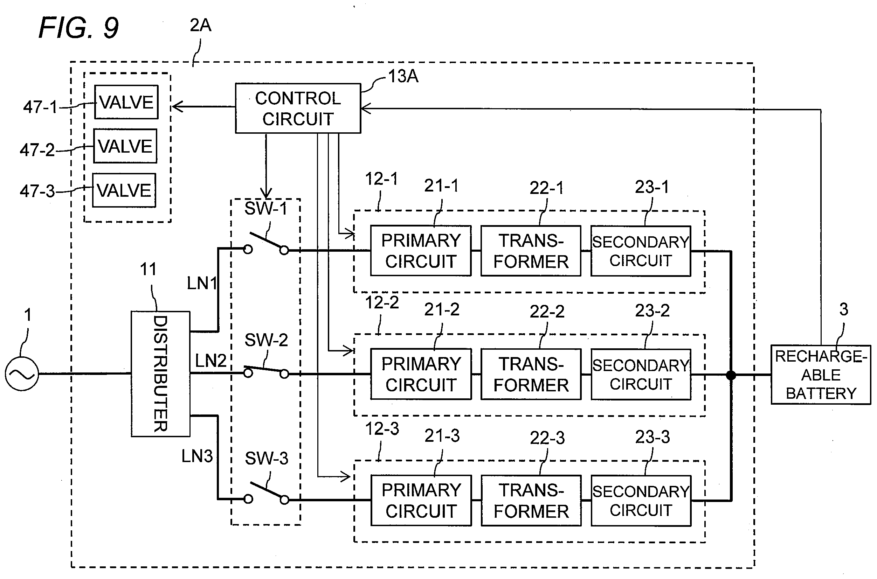

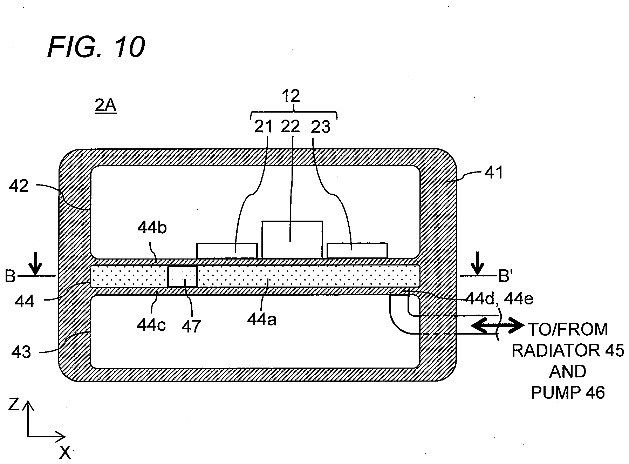

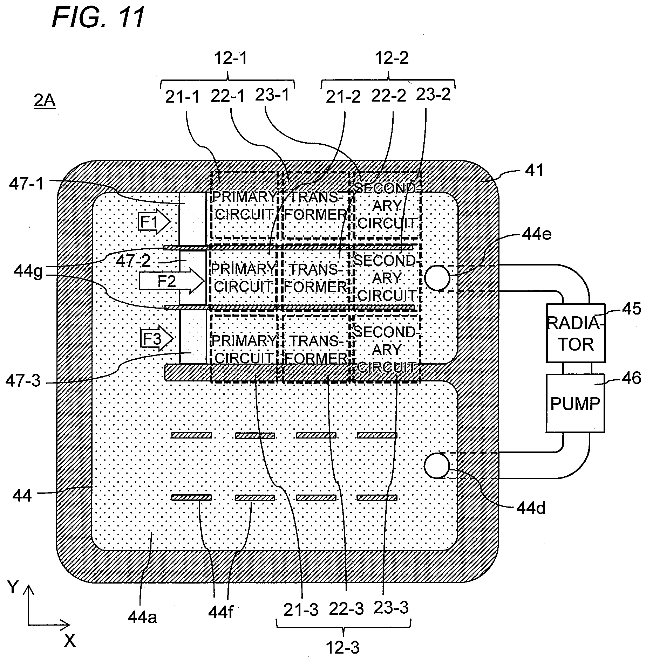

Fig. 9 is a block diagram illustrating a configuration of a charging system provided with a power conversion apparatus 2A according to a modified embodiment of the first embodiment. The power conversion apparatus 2A is provided with a control circuit 13A instead of the control circuit 13 of Fig. 1, and further provided with valves 47-1 to 47-3. The valves 47-1 to 47-3 pass or block the coolant 44a flowing through the flow paths F1 to F3, as described below with reference to Figs. 10 and 11. The valves 47-1 to 47-3 are, e.g., electromagnetic valves. The control circuit 13A controls the switches SW-1 to SW-3 and power conversion circuits 12-1 to 12-3 in a manner similar to that of the control circuit 13 of Fig. 1, and further controls opening and closing of the valves 47-1 to 47-3.

In the present specification, the valves 47-1 to 47-3 are also collectively referred to as "valves 47".

Fig. 10 is a vertical sectional view of a housing 41 for explaining a cooling device for the power conversion apparatus 2A of Fig. 9. Fig. 11 is a horizontal sectional view of the housing 41 for explaining the cooling device for the power conversion apparatus 2A of Fig. 9. Fig. 11 illustrates a cross section taken along line B-B' of Fig. 10. The chamber 44 is provided with partitions 44g that separate the flow paths F1 to F3 from each other. The valves 47-1 to 47-3 are provided in the flow paths F1 to F3, respectively, and pass or block the coolant 44a flowing through the flow paths F1 to F3.

By closing any of the valves 47-1 to 47-3, the flow rate increases in the flow path with the opened valve 47, as compared to a case of opening all the valves 47-1 to 47-3, thus improving the cooling performance of the transformer 22 in thermal contact with this flow path. When the power conversion apparatus 2A is in the light-loaded operation, the control circuit 13A operates one of the plurality of power conversion circuits 12, and stops the operations of the others of the plurality of power conversion circuits 12, as described above. Further, when the power conversion apparatus 2A is in the light-loaded operation, the control circuit 13A opens the valve(s) provided in the flow paths F1 to F3 in thermal contact with the transformers 22 of the power conversion circuits 12 in operation, and closes the valve(s) provided in the flow paths F1 to F3 in thermal contact with the transformers 22 of the power conversion circuits 12 being stopped. The example of Fig. 11 illustrates a case where only the valve 47-2 is opened, and the valves 47-1 and 47-3 are closed. As described above, by increasing the flow rate of the corresponding one of the flow paths F1 to F3 in thermal contact with the transformer 22 of the power conversion circuit 12 in operation, it is possible to improve the cooling performance of the transformer 22 of the power conversion circuit 12 in operation, and it is possible to make the cores 52 less likely to be damaged due to overheating of the transformers 22 than the prior art.

As an example, the inventors have found that when the iron loss of the core 52 is maximized, the temperature of the core 52 decreases by 20 °C by increasing the flow rate from 4 liters/minute to 6 liters/minute.

Although the example of Figs. 10 and 11 illustrates a case where the valves 47 are provided upstream of the transformers 22, the valves 47 may be provided at any positions along the flow paths F1 to F3, e.g., downstream of the transformers 22.

The valve 47 does not need to completely close the flow paths F1 to F3. It is possible to increase the flow rate of the open flow path by partially making the flow difficult.

By using the valves 47, it is possible to well cool the transformer 22 of the power conversion circuit 12 in operation, even when there is no difference in area where each transformer 22 is in thermal contact with the corresponding one of the flow paths F1 to F3. In addition, when operating the power conversion circuit 12 provided with the transformer 22 having the largest thermal contact area with the corresponding one of the flow paths F1 to F3, and stopping the operations of the other power conversion circuits 12, the control circuit 13Amay open the valve 47 provided in one of the flow paths F1 to F3 in thermal contact with the transformer 22 of the power conversion circuit 12 in operation, and close the valves 47 provided in the others of the flow paths F1 to F3 in thermal contact with the transformers 22 of the power conversion circuits 12 being stopped. Accordingly, it is possible to further improve the cooling performance of the transformers 22.

By using the valves 47, it is possible to well cool the transformer 22 of the power conversion circuit 12 in operation, even when the transformers 22 of the power conversion circuits 12 are not in thermal contact with each other. In addition, when operating one power conversion circuit 12 provided with the transformer 22 in thermal contact with at least two other transformers 22, and stopping the operations of the other power conversion circuit 12, the control circuit 13A may open the valve 47 provided in one of the flow paths F1 to F3 in thermal contact with the transformer 22 of the power conversion circuit 12 in operation, and close the valves 47 provided in the other flow paths F1 to F3 in thermal contact with the transformers 22 of the power conversion circuits 12 being stopped. Accordingly, it is possible to further improve the cooling performance of the transformers 22.

### [Advantageous Effects of First Embodiment]

As described above, the power conversion apparatuses 2 and 2A according to the first embodiment can operates one of the plurality of power conversion circuits 12, that is, one power conversion circuit 12 provided with the transformer 22 having the highest cooling performance. As a result, it is possible to make the cores 52 less likely to be damaged due to overheating of the transformers 22 than the prior art, and improve the reliability of the power conversion apparatuses 2 and 2A.

### [SECOND EMBODIMENT]

In a second embodiment, we will describe a power conversion apparatus capable of selectively and sequentially operating a plurality of power conversion circuits in order to prevent overheating of transformers.

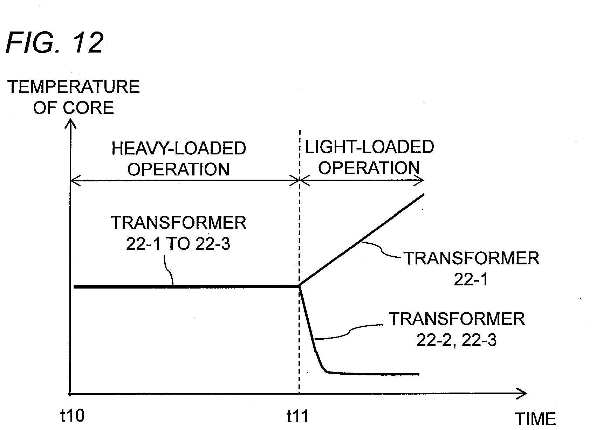

Fig. 12 is a graph schematically showing variations over time in temperatures of the cores 52 of the transformers 22-1 to 22-3 observed when the power conversion apparatus 2 of Fig. 1 is changed from the heavy-loaded operation to the light-loaded operation. Fig. 12 shows a case where the transformers 22-1 to 22-3 of the power conversion apparatus 2 of Fig. 1 do not have sufficient cooling performance. When the power conversion apparatus 2 is in the heavy-loaded operation, that is, when all the power conversion circuits 12-1 to 12-3 are in operation, the temperatures of the cores 52 of the transformers 22-1 to 22-3 are equal to each other. On the other hand, when the power conversion apparatus 2 is in the light-loaded operation, in the example of Fig. 12, when only the power conversion circuit 12-1 is in operation, and the power conversion circuits 12-2 and 12-3 are stopped, the temperature of the core 52 of the transformer 22-1 increases approximately linearly at a rate of about 0.01 °C/sec, and the temperatures of the cores 52 of the transformers 22-2 and 22-3 decrease linearly at a rate of about 0.1 °C/sec. If the operation of Fig. 12 continues, the core 52 of the transformer 22-1 may be overheated and damaged. Therefore, according to the second embodiment, when the power conversion apparatus 2 is in the light-loaded operation, that is, when the load voltage of the rechargeable battery 3 is equal to or higher than the threshold Th, the control circuit 13 selectively and sequentially operates the plurality of power conversion circuits 12 such that one of the plurality of power conversion circuits 12 is operated, and the others of the plurality of power conversion circuits 12 are stopped.

At first, we will describe a case where the power conversion apparatus according to the second embodiment has a configuration similar to that of the power conversion apparatus 2 of Fig. 1.

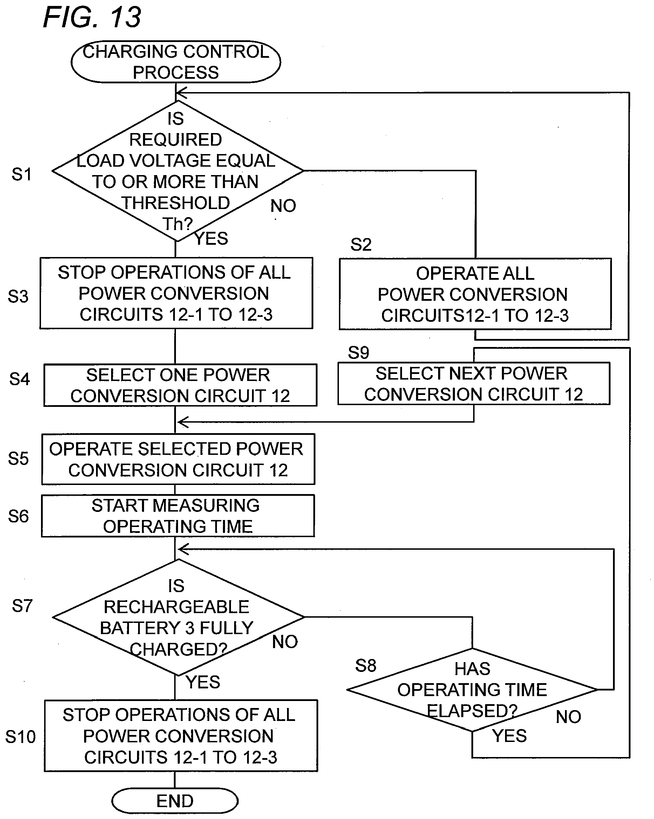

Fig. 13 is a flowchart illustrating a charging control process executed by the control circuit 13 of the power conversion apparatus 2 according to the second embodiment.

In step S1, the control circuit 13 determines whether or not the magnitude of the load voltage required to charge the rechargeable battery 3 is equal to or higher than the predetermined threshold Th: if YES, the process proceeds to step S3; if NO, the process proceeds to step S2. The threshold Th is set to, e.g., a fully-charged voltage of the rechargeable battery 3, as described with reference to Fig. 6.

In step S2, the control circuit 13 turns on and operates all the power conversion circuits 12-1 to 12-3 (heavy-loaded operation), and thereafter, the process periodically returns to step S1.

In step S3, the control circuit 13 stops the operations of all the power conversion circuits 12-1 to 12-3.

In step S4, the control circuit 13 selects one of the power conversion circuits 12-1 to 12-3.

In step S5, the control circuit 13 turns on and operate the selected power conversion circuit 12 (light-loaded operation), and starts supplying power to the rechargeable battery 3.

In step S6, the control circuit 13 starts measuring the operating time of the selected power conversion circuit 12.

In step S7, the control circuit 13 determines whether or not the rechargeable battery 3 has reached the fully-charged voltage: if YES, the process proceeds to step S10; if NO, the process proceeds to step S8.

In step S8, the control circuit 13 determines whether or not the operating time for the selected power conversion circuit 12, that is, a predetermined time period for the selected power conversion circuit 12, has elapsed: if YES, the process proceeds to step S9; if NO, the process returns to step S7.

In step S9, the control circuit 13 selects a next power conversion circuit 12 among the power conversion circuits 12-1 to 12-3 in a predetermined order, and returns to step S5. By repeating steps S5 to S9, for example, the power conversion circuit 12-2 operates next to the power conversion circuit 12-1, the power conversion circuit 12-3 operates next to the power conversion circuit 12-2, the power conversion circuit 12-1 operates next to the power conversion circuit 12-3, and thereafter, the power conversion circuits 12-1 to 12-3 selectively and sequentially operate in a similar manner.

In step S10, the control circuit 13 stops the operations of all the power conversion circuits 12-1 to 12-3.

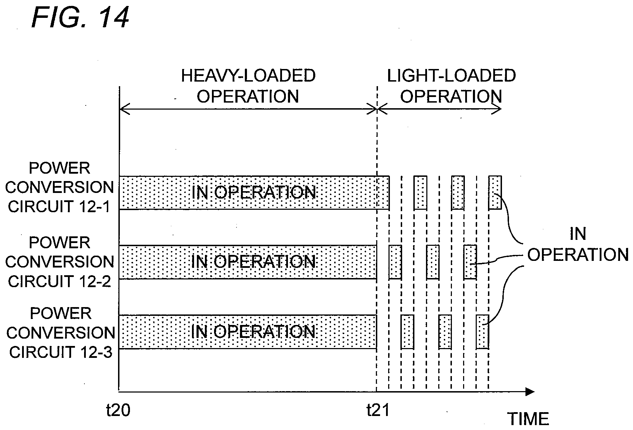

Fig. 14 is a timing chart illustrating operations of the power conversion circuits 12-1 to 12-3 observed when executing the charging control process of Fig. 13. In step S2 of Fig. 13, the power conversion apparatus 2 is in the heavy-loaded operation, and in steps S3 to S9 of Fig. 13, the power conversion apparatus 2 is in the light-loaded operation. When the power conversion apparatus 2 is in the light-loaded operation, the control circuit 13 changes the power conversion circuit 12 in operation among the power conversion circuits 12-1 to 12-3, every time a predetermined time period has elapsed. As a result, when the power conversion apparatus 2 is in the light-loaded operation, the power conversion circuits 12-1 to 12-3 operate, e.g., for the same time period. Each of the power conversion circuits 12-1 to 12-3 is operated during 1/3 of the entire time period during which the power conversion apparatus 2 is in the light-loaded operation, and stops operating during the remaining 2/3 of the entire time period. According to the example described with reference to Fig. 12, the decreasing rate in temperature of the cores 52 of the transformers 22 of the power conversion circuits 12 being stopped is 10 times the increasing rate in temperature of the core 52 of the transformer 22 of the power conversion circuit 12 in operation. Therefore, when the power conversion apparatus 2 is in the light-loaded operation, the temperature of the cores 52 does not effectively increase by changing the power conversion circuit 12 in operation, as illustrated in Fig. 14 .

The time period in step S8 of Fig. 13 is determined based on the increasing rate in temperature of the cores 52, the decreasing rate in temperature of the cores 52, the upper limit value of the temperature at which thermal runaway does not occur, and others. The time period in step S8 of Fig. 13 may be set to, e.g., 1 minute or 2 minutes, so as to spread the core 52 whose temperature increases.

The time period in step S8 of Fig. 13 may be the same or different for the plurality of power conversion circuits 12. In the latter case, when the power conversion apparatus 2 is in the light-loaded operation, the control circuit 13 may selectively and sequentially operate the plurality of power conversion circuits 12 such that each of the plurality of power conversion circuits 12 have a total operating time length for a predetermined long time period, and the total operating time lengths of the power conversion circuits 12 are equal to each other. In addition, when the power conversion apparatus 2 is in the light-loaded operation, the control circuit 13 may selectively and sequentially operate the plurality of power conversion circuits 12 so as to allocate a longer operating time length to the power conversion circuit 12 provided with the transformer 22 having higher cooling performance. For example, as described above, the transformer 22 having a larger thermal contact area with the flow paths F1 to F3 has higher cooling performance, and the transformer 22 in thermal contact with more transformers 22 has higher cooling performance.

As described above, by selectively and sequentially operating the plurality of power conversion circuits 12 based on the operating times thereof, it is possible to make the cores 52 less likely to be damaged due to overheating of the transformers 22 than the prior art. By selectively and sequentially operating the plurality of power conversion circuits 12, it is possible to balance deterioration of circuits and apparatuses due to continuous use for a long time, thus contributing to extension of lifetimes of products.

### [First Modified Embodiment of Second Embodiment]

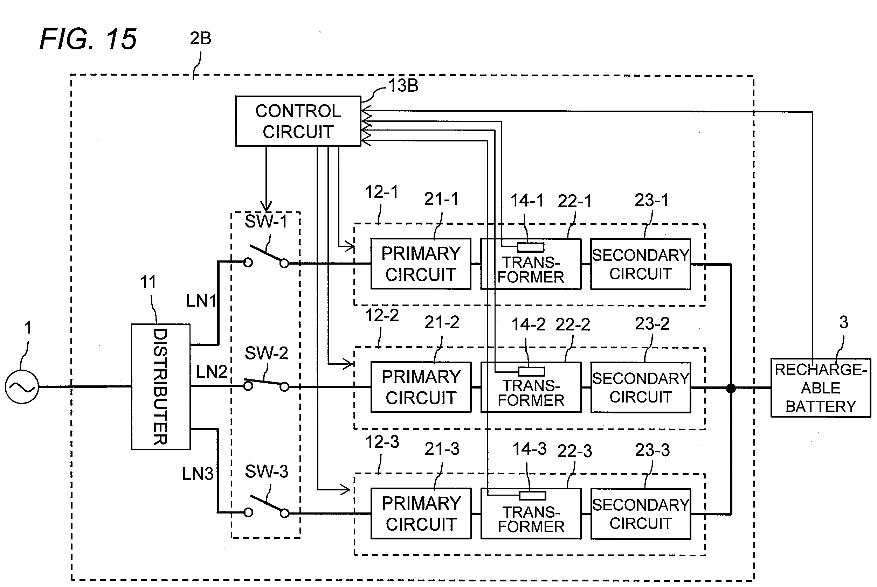

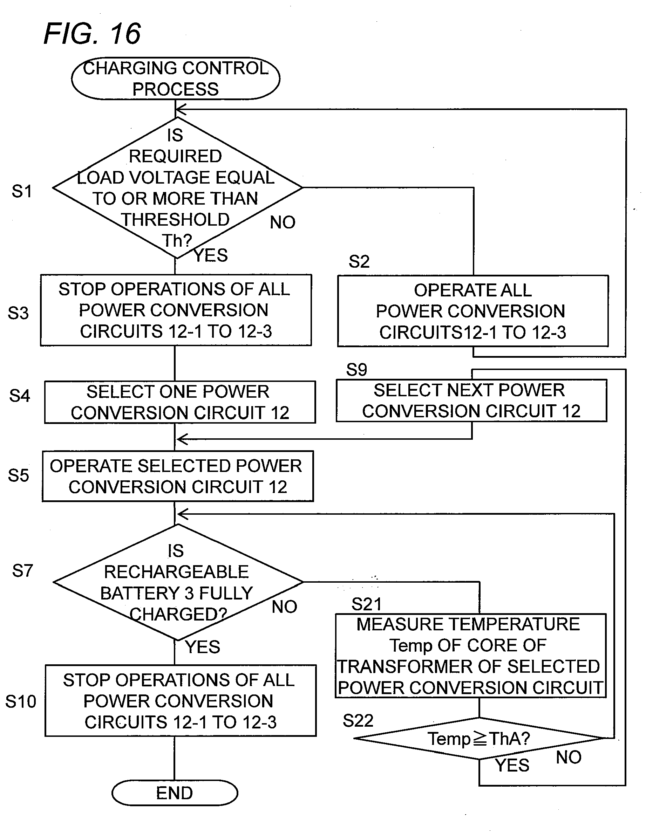

Fig. 15 is a block diagram illustrating a configuration of a charging system provided with a power conversion apparatus 2B according to a first modified embodiment of the second embodiment. The power conversion apparatus 2B is provided with a control circuit 13B instead of the control circuit 13 of Fig. 1, and further provided with temperature sensors 14-1 to 14-3. The temperature sensors 14-1 to 14-3 measure the temperatures of the cores 52 of the transformers 22-1 to 22-3, respectively. The control circuit 13B executes a charging control process described with reference to Fig. 16, based on the temperatures of the cores 52 measured by the temperature sensors 14-1 to 14-3.

Fig. 16 is a flowchart illustrating a charging control process executed by the control circuit 13B of the power conversion apparatus 2B of Fig. 15. The charging control process of Fig. 16 includes steps S21 to S22, instead of steps S6 and S8 of Fig. 13. The control circuit 13B proceeds to step S7 after step S5, and if NO in step S7, proceeds to step S21.

In step S21, the control circuit 13B measures the temperature Temp of the core 52 of the transformer 22 in the selected power conversion circuit 12.

In step S22, the control circuit 13B determines whether or not the temperature Temp is equal to or higher than a predetermined threshold ThA: if YES, the process proceeds to step S9; if NO, the process returns to step S7. The threshold ThA may be set to, e.g., 80 °C to 90 °C, a temperature at which the iron loss of the core 52 shown in Fig. 7 is minimized, that is, a temperature at which the iron loss of the core 52 starts to increase.

By executing the charging control process of Fig. 16, when the power conversion apparatus 2B is in the light-loaded operation, the control circuit 13B changes the power conversion circuit 12 in operation, every time the temperature of the transformer 22 of the power conversion circuit 12 in operation is equal to or higher than the threshold ThA.

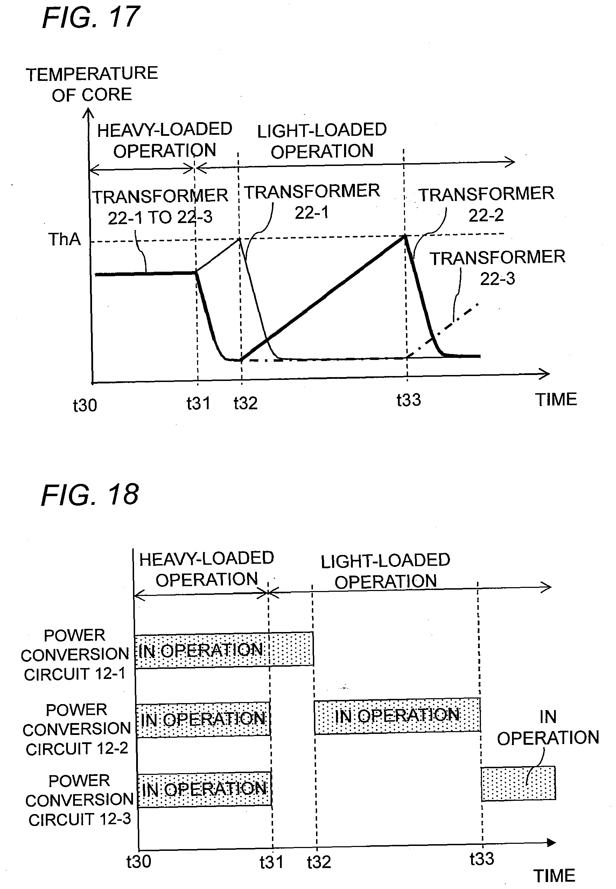

Fig. 17 is a graph schematically showing variations over time in temperatures of the cores 52 of the transformers 22-1 to 22-3 observed when executing the charging control process of Fig. 16. Fig. 18 is a timing chart illustrating operations of the power conversion circuits 12-1 to 12-3 observed when executing the charging control process of Fig. 16. In step S2 of Fig. 16, the power conversion apparatus 2B is in the heavy-loaded operation, and in steps S3 to S5, S7, S21, S22, and S9 of Fig. 16, the power conversion apparatus 2B is in the light-loaded operation. In the example of Fig. 18, when starting the light-loaded operation, the power conversion circuit 12-1 initially operates. The temperature of the core 52 of the transformer 22-1 increases due to the iron loss of the core 52 and the like. The control circuit 13B monitors the temperature of the core 52 of the transformer 22-1, and when the temperature of the core 52 is equal to or higher than the threshold ThA, the control circuit 13B stops the operation of the power conversion circuit 12-1, and starts the operation of the power conversion circuit 12-2. As a result, the temperature of the core 52 of the transformer 22-1 of the power conversion circuit 12-1 having stopped turns to decrease, and quickly approaches the temperature of the coolant 44a. The core 52 of the transformer 22-2 of the power conversion circuit 12-2 has been cooled before starting the operation of the power conversion circuit 12-2, but gradually increases after starting the operation of the power conversion circuit 12-2. The control circuit 13B monitors the temperature of the core 52 of the transformer 22-2, and when the temperature of the core 52 is equal to or higher than the threshold ThA, the control circuit 13B stops the operation of the power conversion circuit 12-2, and starts the operation of the power conversion circuit 12-3. When the power conversion apparatus 2B is in the light-loaded operation, the iron loss of the core 52 significantly increases, but a disequilibrium thermal distribution of the core 52 does not occur, and therefore, the core 52 is less likely to be damaged, and it is possible to obtain the power conversion apparatus 2B which is highly reliable.

In addition, when the iron loss of the cores 52 of the transformers 22 has the temperature characteristic as shown in Fig. 7, the control circuit 13B may change the power conversion circuit 12 in operation, so as to operate in a range around 80 to 90 °C at which the iron loss is minimized, e.g., in a range of 70 to 100 °C. As a result, the power conversion apparatus 2B can operate efficiently, even in the light-loaded operation which typically results in decreased efficiency.

As described above, by selectively and sequentially operating the plurality of power conversion circuits 12 based on the temperatures of the transformers 22, it is possible to make the cores 52 less likely to be damaged due to overheating of the transformers 22 than the prior art.

### [Second Modified Embodiment of Second Embodiment]

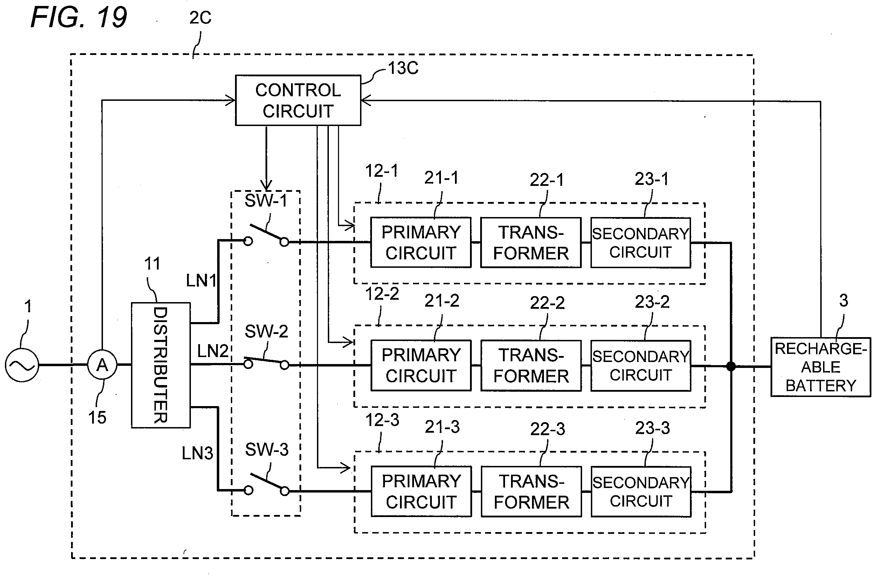

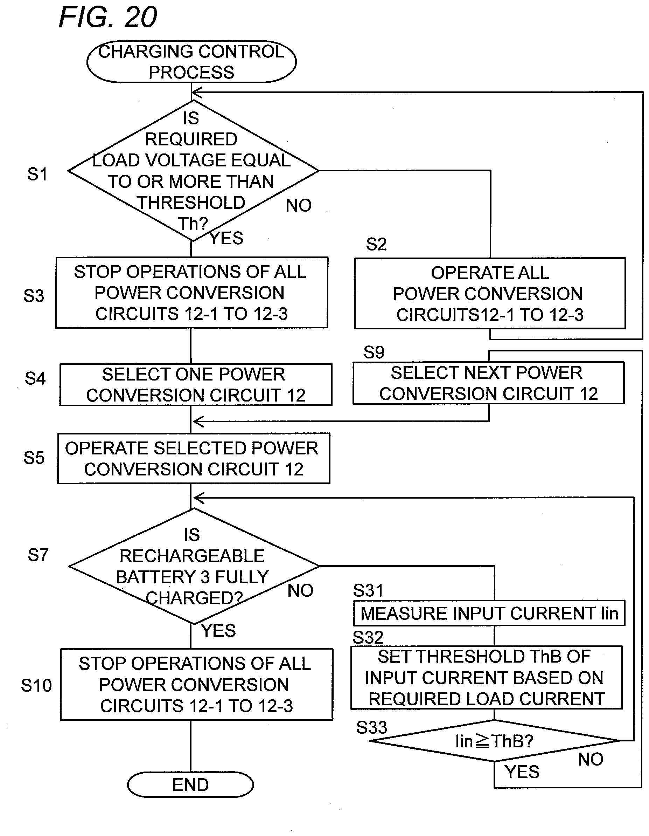

Fig. 19 is a block diagram illustrating a configuration of a charging system provided with a power conversion apparatus 2C according to a second modified embodiment of the second embodiment. The power conversion apparatus 2C is provided with a control circuit 13C instead of the control circuit 13 of Fig. 1, and further provided with a current sensor 15. The current sensor 15 measures input currents of the power conversion circuits 12. The control circuit 13C executes a charging control process described with reference to Fig. 20, based on the input currents measured by the current sensor 15.

Fig. 20 is a flowchart illustrating a charging control process executed by the control circuit 13C of the power conversion apparatus 2C of Fig. 19. The charging control process of Fig. 20 includes steps S31 to S33 instead of steps S21 to S22 of Fig. 16. If NO in step S7, the control circuit 13C proceeds to step S31.

In step S31, the control circuit 13C measures the input current Iin of the selected power conversion circuit 12.

In step S32, the control circuit 13C sets a threshold ThB of the input current, based on the magnitude of the load current required to charge the rechargeable battery 3.

In step S33, the control circuit 13C determines whether or not the input current Iin is equal to or higher than the threshold ThB: if YES, the process proceeds to step S9; if NO, the process returns to step S7.

By executing the charging control process of Fig. 20, when the power conversion apparatus 2C is in the light-loaded operation, the control circuit 13C changes the power conversion circuit 12 in operation, every time the input current of the power conversion circuit 12 in operation is equal to or higher than the threshold ThB determined based on the load current of the rechargeable battery 3.

In general, the output current of the power conversion circuit 12 is controlled based on the magnitude of the load current required to charge the rechargeable battery 3. However, when the iron loss of the core 52 of the transformer 22 increases, and the efficiency of the power conversion circuit 12 decreases, a desired output current cannot be achieved unless the input current is increased. Therefore, the control circuit 13C measures the input current Iin of the primary circuit 21 of the transformer 22, and when the input current Iin is equal to or higher than the predetermined threshold ThB, changes the power conversion circuit 12 in operation. In addition, since the load current required to charge the rechargeable battery 3 gradually decreases during the light-loaded operation as described with reference to Fig. 6, the control circuit 13C recalculates the threshold ThB when the load current varies. As described above, by selectively and sequentially operating the plurality of power conversion circuits 12 based on the input current Iin, it is possible to make the cores 52 less likely to be damaged due to overheating of the transformers 22 than the prior art.

In addition, when the power conversion apparatus 2C is in the light-loaded operation, only one of the power conversion circuits 12-1 to 12-3 is in operation. Therefore, it is possible to measure the input current of each of the power conversion circuits 12-1 to 12-3, using one current sensor 15 provided upstream of the distributor 11 as illustrated in Fig. 19. Alternatively, a current sensor for measuring the input current of each of the power conversion circuits 12-1 to 12-3 may be provided for each of the power conversion circuits 12-1 to 12-3.

### [Third Modified Embodiment of Second Embodiment]

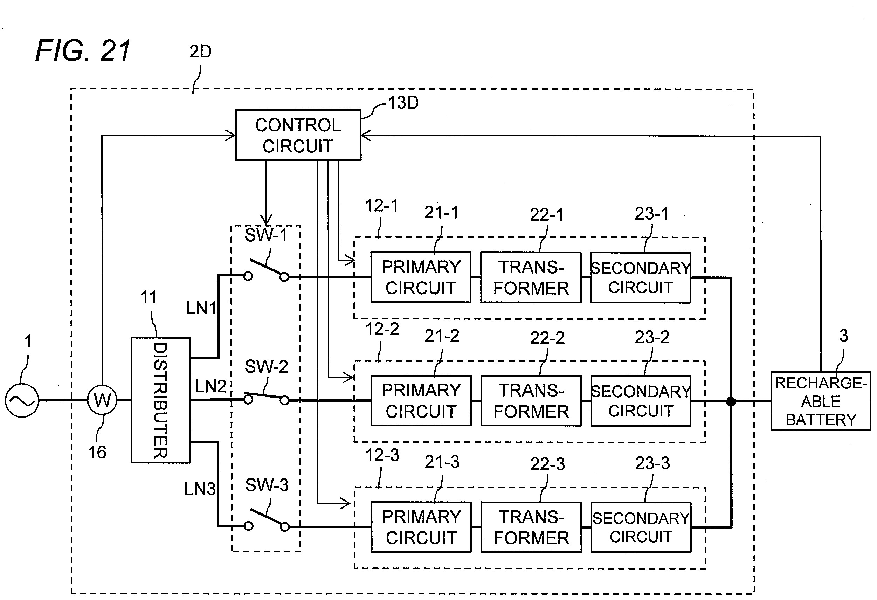

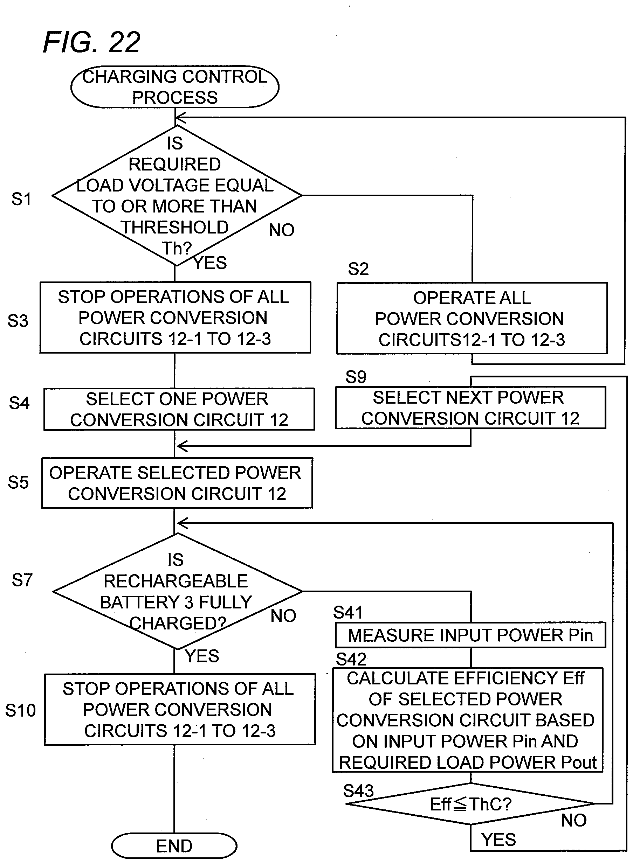

Fig. 21 is a block diagram illustrating a configuration of a charging system provided with a power conversion apparatus 2D according to a third modified embodiment of the second embodiment. The power conversion apparatus 2D is provided with a control circuit 13D instead of the control circuit 13 of Fig. 1, and further provided with a power sensor 16. The power sensor 16 measures input powers of the power conversion circuits 12. The power sensor 16 may be a single sensor, or a combination of a current sensor and a voltage sensor. The control circuit 13D executes a charging control process described with reference to Fig. 22, based on the input power measured by the power sensor 16.

Fig. 22 is a flowchart illustrating the charging control process executed by the control circuit 13D of the power conversion apparatus 2D of Fig. 21. The charging control process of Fig. 22 includes steps S41 to S43 instead of steps S21 to S22 of Fig. 16. If NO in step S7, the control circuit 13D proceeds to step S41.

In step S41, the control circuit 13D measures input power Pin of the selected power conversion circuit 12.

In step S42, the control circuit 13D calculates efficiency Eff of the selected power conversion circuit 12, Eff = Pout/Pin, based on the input power Pin, and the load power Pout required to charge the rechargeable battery 3. The control circuit 13D may receive a control signal from the rechargeable battery 3, the control signal indicating the magnitudes of the load current and the load voltage required to charge the rechargeable battery 3, and calculate the load power Pout based on the load current and the load voltage. Further, the control circuit 13D may receive the control signal indicating the magnitude of the load power Pout, from the rechargeable battery 3.

In step S43, the control circuit 13D determines whether or not the efficiency Eff is equal to or smaller than a predetermined threshold ThC: if YES, the process proceeds to step S9; if NO, the process proceeds to step S7.

By executing the charging control process of Fig. 22, when the power conversion apparatus 2D is in the light-loaded operation, the control circuit 13D calculates the efficiency of the power conversion circuit 12 in operation, based on the input power of the power conversion circuit 12 in operation, and based on the load power of the rechargeable battery 3, and then changes the power conversion circuit 12 in operation, every time the efficiency is equal to or smaller than the threshold ThC.

As described above, by selectively and sequentially operating the plurality of power conversion circuits 12 based on the efficiency Eff thereof, it is possible to make the cores 52 less likely to be damaged due to overheating of the transformers 22 than the prior art.

In addition, when the power conversion apparatus 2D is in the light-loaded operation, only one of the power conversion circuits 12-1 to 12-3 is in operation. Therefore, it is possible to measure the input power of each of the power conversion circuits 12-1 to 12-3, using one power sensor 16 provided upstream of the distributor 11 as illustrated in Fig. 21. Alternatively, a power sensor for measuring the input power of each of the power conversion circuits 12-1 to 12-3 may be provided for each of the power conversion circuits 12-1 to 12-3.

### [Advantageous Effects of Second Embodiment]

Since o the power conversion apparatuses 2 and 2B to 2D according to the second embodiment selectively and sequentially operate the plurality of power conversion circuits 12, it is possible to make the cores 52 less likely to be damaged due to overheating of the transformers 22 than the prior art, and improve the reliability of the power conversion apparatuses 2 and 2B to 2D.

Since the power conversion apparatuses 2 and 2B to 2D according to the second embodiment selectively and sequentially operate the plurality of power conversion circuits 12, the temperature of the cores 52 of the transformers 22 is less likely to increase than the prior art, even without the cooling device as illustrated in Figs. 4 and 5.

For example, even in a case where a transformer is provided with a water passage for cooling as in Patent Document 2, a large temperature difference may occur in the core by cooling only a part of the core, and therefore, stress may occur in the core due to the temperature difference, and the core may be damaged. On the other hand, according to the power conversion apparatuses 2 and 2B to 2D of the second embodiment, by selectively and sequentially operating the plurality of power conversion circuits 12, the temperature of the cores 52 of the transformers 22 is less likely to increase, and therefore, a large temperature difference is less likely to occur. As a result, it is possible to make the cores 52 less likely to be damaged than the prior art.

### [Other Modified Embodiments]

The valves 47 described with reference to Figs. 9 to 11 may be applied to the power conversion apparatuses 2 and 2B to 2D according to the second embodiment. In this case, the control circuits 13 and 13B to 13D open the valve provided in one of the flow paths F1 to F3 in thermal contact with the transformer 22 of the power conversion circuit 12 in operation, and close the valves provided in the others of the flow paths F1 to F3 in thermal contact with the transformers 22 of the power conversion circuit 12 being stopped. Accordingly, it is possible to further improve the cooling performance of the transformers 22.

In the above description, we have described the case where the power conversion apparatus 2 transitions from the heavy-loaded operation to the light-loaded operation when the load voltage required to charge the rechargeable battery 3 reaches the fully-charged voltage Th of the rechargeable battery 3, but it is not limited thereto. The power conversion apparatus 2 may transition from the heavy-loaded operation to the light-loaded operation when the load voltage is equal to or higher than a predetermined threshold lower than the fully-charged voltage Th.

In the above description, we have described the case where the power conversion apparatus 2 transitions from the heavy-loaded operation to the light-loaded operation based on the load voltage required to charge the rechargeable battery 3, but it is not limited thereto. The power conversion apparatus 2 may transition from the heavy-loaded operation to the light-loaded operation based on the load current or the load power required to charge the rechargeable battery 3.

In the above description, we mainly described the case where overheating of the transformer 22 should be less likely to occur. However, the power conversion apparatus according to the embodiment of the present disclosure may be configured such that overheating of the primary circuits 21, the secondary circuits 23, and/or other heat generating components is less likely to occur.

Referring to Fig. 1 and others, we have described the case where the power conversion apparatus 2 is supplied with three-phase AC power from the three-phase AC power supply 1. However, the power conversion apparatus according to the embodiment of the present disclosure may be configured to be supplied with power from one or more single-phase AC power supplies, or supplied with power from one two-phase AC power supply. When the power conversion apparatus is supplied with power from one single-phase AC power supply, the distributor 11 may supply the same AC power to the three power conversion circuits 12. Alternatively, when the power conversion apparatus is supplied with power from two single-phase AC power supplies, the distributor 11 may supply AC power of one AC power supply to one power conversion circuit 12, and supply AC power of the other AC power supply to another power conversion circuit 12. In this case, the control circuit 13 stops the operation of the remaining one power conversion circuit 12. Alternatively, when the power conversion apparatus is supplied with power from three single-phase AC power supplies, the distributor 11 may supply the AC power of the AC power supplies to the power conversion circuits 12 on a one-to-one basis. Alternatively, when the power conversion apparatus is supplied with power from the two-phase AC power supply, the distributor 11 may supply AC power of one phase to one power conversion circuit 12, and supply AC power of the other phase to another power conversion circuit 12. In this case, the control circuit 13 stops the operation of the remaining one power conversion circuit 12.

The power conversion apparatus according to the embodiment of the present disclosure may be configured to be supplied with power from one or more DC power supplies. In this case, the distributor 11 supplies power to the three power conversion circuits 12 in a manner similar to the case of being supplied with power from one or more single-phase AC power supplies, and the diodes D1 to D4 and the power factor correction circuit 31 of the primary circuit 21 of each power conversion circuit 12 are omitted.

The power conversion apparatus according to the embodiment of the present disclosure may be provided with two or four or more power conversion circuits.

The power conversion apparatus according to the embodiment of the present disclosure may be provided with any power conversion circuits each including a transformer, and it is not limited to the power conversion circuits 12 including the LLC resonance DC/DC converter circuits.

The power conversion apparatus according to the embodiment of the present disclosure may be configured to supply DC power to any load apparatus with a variable load voltage, and it is not limited to the rechargeable battery 3.

### INDUSTRIAL APPLICABILITY

The power conversion apparatus according to one aspect of the present disclosure is applicable to, e.g., an on-board charging system for an electric vehicle or a plug-in hybrid vehicle.

### REFERENCE SIGNS LIST

1: AC POWER SUPPLY
2, 2A to 2D: POWER CONVERSION APPARATUS
3: RECHARGEABLE BATTERY
11: DISTRIBUTOR
12-1 to 12-3: POWER CONVERSION CIRCUIT
13, 13A to 13D: CONTROL CIRCUIT
14-1 to 14-3: TEMPERATURE SENSOR
15: CURRENT SENSOR
16: POWER SENSOR
21-1 to 21-3: PRIMARY CIRCUIT
22-1 to 22-3: TRANSFORMER
23-1 to 23-3: SECONDARY CIRCUIT
31: POWER FACTOR CORRECTION CIRCUIT
41: HOUSING
42, 43, 44: CHAMBER
44a: COOLANT
44b, 44c: WALL
44d: INLET
44e: OUTLET
44f: FIN
44g: PARTITION
45: RADIATOR
46: PUMP
47-1 to 47-3: VALVE
51: BOBBIN
52: CORE
53: POTTING
C1 to C3: CAPACITOR
D1 to D8: DIODE
L1: PRIMARY WINDING
L2: SECONDARY WINDING
L3: LEAKAGE INDUCTANCE
Q1 to Q4: SWITCHING ELEMENT
SW-1 to SW-3: SWITCH

## Claims

1. A power conversion apparatus comprising:
a plurality of power conversion circuits each comprising a transformer and supplying DC power to a common load apparatus;
a control circuit configured to control the power conversion circuits; and
a cooling device configured to cool the power conversion circuits,
wherein the cooling device comprises at least one flow path for a coolant, the flow path being in thermal contact with the transformers of the power conversion circuits, and
wherein, when a load voltage of the load apparatus is equal to or higher than a predetermined threshold, the control circuit operates one power conversion circuit of the plurality of power conversion circuits, the one power conversion circuit comprising the transformer having a largest thermal contact area with the flow path, and stops operations of other power conversion circuits of the plurality of power conversion circuits.

2. The power conversion apparatus as claimed in claim 1,
wherein the transformers of the power conversion circuits are arranged so as to be in thermal contact with each other.

3. The power conversion apparatus as claimed in claim 2,
wherein the power conversion apparatus comprises three or more power conversion circuits, and
wherein the transformers of the power conversion circuits are arranged such that the one transformer having the largest thermal contact area with the flow path is in thermal contact with at least two other transformers.

4. The power conversion apparatus as claimed in any one of claims 1 to 3,
wherein the cooling device further comprises: a plurality of flow paths for the coolant; and a plurality of valves provided in the plurality of flow paths, respectively, and
wherein, when the load voltage of the load apparatus is equal to or higher than the predetermined threshold, the control circuit opens one valve provided in the flow path in thermal contact with the transformer of the one power conversion circuit in operation, and closes other valves provided in the flow paths in thermal contact with the transformers of the other power conversion circuits being stopped.

5. A power conversion apparatus comprising:
three or more power conversion circuits each comprising a transformer and supplying DC power to a common load apparatus;
a control circuit configured to control the power conversion circuits; and
a cooling device configured to cool the power conversion circuits,
wherein the cooling device comprises at least one flow path for a coolant, the flow path being in thermal contact with the transformers of the power conversion circuits,
wherein the transformers of the power conversion circuits are arranged so as to be in thermal contact with each other, and
wherein, when a load voltage of the load apparatus is equal to or higher than a predetermined threshold, the control circuit operates one power conversion circuit of the three or more power conversion circuits, the one power conversion circuit comprising the transformer in thermal contact with at least two other transformers, and stops operations of other power conversion circuits of the three or more power conversion circuits.

6. The power conversion apparatus as claimed in claim 5,
wherein the cooling device further comprises: a plurality of flow paths for the coolant; and a plurality of valves provided in the plurality of flow paths, respectively, and
wherein, when the load voltage of the load apparatus is equal to or higher than the predetermined threshold, the control circuit opens one valve provided in the flow path in thermal contact with the transformer of the one power conversion circuit in operation, and closes other valves provided in the flow paths in thermal contact with the transformers of the other power conversion circuits being stopped.

7. A power conversion apparatus comprising:
a plurality of power conversion circuits each comprising a transformer and supplying DC power to a common load apparatus;
a control circuit configured to control the power conversion circuits; and
a cooling device configured to cool the power conversion circuits,
wherein the cooling device comprises: a plurality of flow paths for a coolant, the flow paths being in thermal contact with the transformers of the power conversion circuits; and a plurality of valves provided in the plurality of flow paths, respectively, and
wherein, when a load voltage of the load apparatus is equal to or higher than a predetermined threshold, the control circuit operates one power conversion circuit of the plurality of power conversion circuits, stops operations of other power conversion circuits of the plurality of power conversion circuits, opens one valve provided in the flow path in thermal contact with the transformer of the one power conversion circuit in operation, and closes other valves provided in the flow paths in thermal contact with the transformers of the other power conversion circuits being stopped.

8. The power conversion apparatus as claimed in any one of claims 1 to 7,
wherein the power conversion apparatus comprises three power conversion circuits, and
wherein each of the three power conversion circuits converts each single-phase AC power of three-phase AC power supplied from a three-phase AC power supply, into DC power.

9. A charging system including:
the power conversion apparatus as claimed in any one of claims 1 to 8; and
a rechargeable battery as the load apparatus common to the plurality of power conversion circuits of the power conversion apparatus, the rechargeable battery being supplied with DC power from the plurality of power conversion circuits for charging.

10. A method for controlling a power conversion apparatus, the power conversion apparatus comprising: a plurality of power conversion circuits each comprising a transformer and supplying DC power to a common load apparatus; and a cooling device configured to cool the power conversion circuits,
wherein the cooling device comprises at least one flow path for a coolant, the flow path being in thermal contact with the transformers of the power conversion circuits,
wherein, when a load voltage of the load apparatus is equal to or higher than a predetermined threshold, the control method includes the steps of: operating one power conversion circuit of the plurality of power conversion circuits, the one power conversion circuit comprising the transformer having a largest thermal contact area with the flow path, and stopping operations of other power conversion circuits of the plurality of power conversion circuits.

11. A method for controlling a power conversion apparatus, the power conversion apparatus comprising: a plurality of power conversion circuits each comprising a transformer and supplying DC power to a common load apparatus; and a cooling device configured to cool the power conversion circuits,
wherein the cooling device comprises at least one flow path for a coolant, the flow path being in thermal contact with the transformers of the power conversion circuits, and
wherein the transformers of the power conversion circuits are arranged so as to be in thermal contact with each other,
wherein, when a load voltage of the load apparatus is equal to or higher than a predetermined threshold, the control method includes the steps of: operating one power conversion circuit of the plurality of power conversion circuits, the one power conversion circuit comprising the transformer in thermal contact with at least two other transformers, and stopping operations of other power conversion circuits of the plurality of power conversion circuits.

12. A method for controlling a power conversion apparatus, the power conversion apparatus comprising: a plurality of power conversion circuits each comprising a transformer and supplying DC power to a common load apparatus; and a cooling device configured to cool the power conversion circuits,
wherein the cooling device comprises: a plurality of flow paths for a coolant, the flow paths being in thermal contact with the transformers of the power conversion circuits; and a plurality of valves provided in the plurality of flow paths, respectively
wherein, when a load voltage of the load apparatus is equal to or higher than a predetermined threshold, the control method includes the steps of: operating one power conversion circuit of the plurality of power conversion circuits, stopping operations of other power conversion circuits of the plurality of power conversion circuits, opening one valve provided in the flow path in thermal contact with the transformer of the one power conversion circuit in operation, and closing other valves provided in the flow paths in thermal contact with the transformers of the other power conversion circuits being stopped.
